# EUROPEAN PATENT APPLICATION

(11) **EP 4 572 120 A1**
(43) Date of publication of application: **18.06.2025**
(21) Application number: 23217307.0
(22) Date of filing: 15.12.2023
(51) Int. Cl.: H02M 7/483, H02M 1/32

(54) **MULTILEVEL CONVERTER AND METHOD FOR CONTROLLING A MULTILEVEL CONVERTER**

(71) Applicant: Rimac Technology LLC, 10431 Sveta Nedelja (HR)
(72) Inventor: Szemberg O'Connor, Teddy, E3 5EG London (GB)
(74) Representative: Sonnenberg Harrison Partnerschaft mbB

(57) **Abstract**

What is proposed is a method for controlling a multilevel converter comprising a plurality of energy sources and a plurality of power converter modules, each power converter module comprising at least two switching elements, the method comprising:
selectively switching (S 1) at least one of the plurality of power converter modules and/or at least one of the plurality of energy sources into a diagnostic state;
in the diagnostic state, charging or discharging (S2) the at least one of the plurality of power converter modules and/or the at least one of the plurality of energy sources at a predetermined charge or discharge rate until a predetermined criterion is reached, and
when the predetermined criterion is reached, selectively switching (S3) the at least one of the plurality of power converter modules and/or the at least one of the plurality of energy sources from the diagnostic state into a non-diagnostic state.

## Description

### TECHNICAL FIELD OF THE INVENTION

The present invention relates to a method for controlling a multilevel converter. Furthermore, the present invention relates to a multilevel converter. Also, the present invention relates to an electric vehicle comprising at least a multilevel converter.

### BACKGROUND OF THE INVENTION

The demand for reliable and efficient energy storage solutions has grown significantly with the increasing integration of (renewable) energy sources and the need for grid stability. In this context, the concept of an AC battery operatable as stand-alone solutions or connectable to a grid, also known as a battery-supplied multilevel converter, has emerged as a promising technology. Such a system combines the benefits of energy storage batteries with the flexibility and functionality of a multilevel converter, enabling seamless integration and operation within an alternating current (AC) power grid.

The battery-supplied multilevel converter may function as a bridge between the grid and the energy source, such as an energy storage battery, facilitating bidirectional power flow and ensuring optimal utilization of stored energy. By utilizing a multilevel converter architecture, which consists of multiple power converter modules with varying voltage levels, the system achieves enhanced voltage quality, reduced harmonic distortion, and improved power flow control.

During normal operation, the AC battery operates by switching the energy sources in a dynamically defined schedule to produce an alternating voltage. Thereby, the AC battery is sized such that it may continue normal operation if one energy source or a module comprising multiple energy sources is switched out, i.e., bypassed. This allows the AC battery to continue operation in case of a single energy source or module failure.

Also, concerning AC batteries, maintaining a clear understanding of a health and/or performance of the respective energy sources over time is paramount. To achieve this, a rigorous assessment process is usually employed, involving a series of carefully defined tests conducted at regular intervals throughout a device's lifespan. These evaluations are typically carried out on an annual basis or in a predetermined time interval, providing valuable insights into the device's condition and functionality.

However, the challenge here lies in the fact that these predefined testing conditions seldom occur in the everyday operational parameters of the system. Consequently, the entire AC battery must be temporarily taken offline for the duration of these assessments, resulting in a notable loss of operational time.

This necessity underscores the delicate balance between ensuring the AC battery's health and minimizing downtime, and thus, is a critical concern in the realm of electrochemical technology.

### SUMMARY OF THE INVENTION

Against this background, it is an object of the present invention to provide an improved multilevel converter (i.e., an AC battery) and/or an improved method for controlling a multilevel converter.

The object is attained by a method for controlling a multilevel converter having the features of claim 1. Furthermore, the object is attained by a multilevel converter having the features of claim 13. Also, the method is attained by an electric vehicle comprising at least one multilevel converter having the features of claim 15.

Advantageous embodiments of the present disclosure are the subject matter of the dependent claims. Naturally, the explanations given in connection with the method for controlling a multilevel converter equivalently relate to the multilevel converter and/or the elective vehicle comprising at least one multilevel converter according to the present disclosure without being mentioned redundantly in its/their context. In particular, linguistically common rephrasing and/or an analogous replacement of respective terms within the scope of common linguistic practice, in particular the use of synonyms backed by the generally recognized linguistic literature, are, of course, comprised by the content of the disclosure at hand without every variation having to be expressly mentioned.

In accordance with a first aspect, a method for controlling a multilevel converter is provided. The multilevel converter comprises a plurality of energy sources and a plurality of power converter modules, each power converter module comprising at least two switching elements. The method comprising selectively switching at least one of the plurality of power converter modules and/or at least one of the plurality of energy sources into a diagnostic state; in the diagnostic state, charging or discharging the at least one of the plurality of power converter modules and/or the at least one of the plurality of energy sources at a predetermined charge or discharge rate or observing the at least one of the plurality of power converter modules and/or the at least one of the plurality of energy sources until a respective predetermined criterion is reached, and when the predetermined criterion is reached, selectively switching the at least one of the plurality of power converter modules and/or the at least one of the plurality of energy sources from the diagnostic state into a non-diagnostic state.

Here, "selectively switching the at least one of the plurality of power converter modules and/or the at least one of the plurality of energy sources from the diagnostic state into a non-diagnostic state" may also refer to preferably selectively switching the at least one of the plurality of power converter modules and/or the at least one of the plurality of energy sources from the diagnostic state to a state different from the diagnostic state.

One of the mentionable advantages of the claimed method is that it provides the possibility of selectively switching the plurality of power converter modules and/or the plurality of energy sources with respect to one another in varying manners. Furthermore, the method enables at least one diagnostic test to be carried out while other power converter modules and/or energy sources remain operational. Thereby, the method precludes the need to disconnect the entire system in order to carry out at least one diagnostic test on a module or energy source level. In view of the prior art, the claimed method has the advantage that it enables the possibility to keep the multilevel converter in normal operation and at the same time, to perform at least one diagnostics test for at least one of the plurality of power converter modules and/or at least one of the plurality of energy sources, by switching said at least one of the plurality of power converter modules and/or said at least one of the plurality of energy sources in the diagnostic mode. This possibility is enabled by the AC-topology of the multilevel converter, making it possible to selectively switch the plurality of power converter modules and/or the plurality of energy sources with respect to one another in varying manners. By preferably periodically subjecting the power converter modules and/or energy sources to diagnostic testing, the method helps identify and rectify potential issues early, leading to improved overall reliability and reduced risk of unexpected failures. Furthermore, the method ensures that the multilevel converter operates optimally by monitoring and maintaining the health of its components. This, in turn, leads to consistent and efficient performance. Although the diagnostic testing requires temporary switching of modules and/or energy sources to a diagnostic state, the ability to detect and/or address issues promptly can prevent larger, unplanned downtime in the future. By charging or discharging the energy sources at a predetermined rate and monitoring against specific criteria, the method promotes energy efficiency by identifying any inefficiencies or abnormalities that may be present in the system. The early detection of potential issues and improved system performance may also lead to cost savings in terms of maintenance and repair. Furthermore, a reduction of a system's downtime can be achieved. In particular, with the presented method, a system's shutdown that may otherwise occur after a certain time, for example each year, to test the system against warranty conditions can be avoided. The method allows for the selective switching of power converter modules and energy sources, optimizing the use of available resources based on their condition and performance. This can lead to better resource utilization and potentially extend the lifespan of these components.

"Energy sources" preferably refer to the individual components or units within the multilevel converter topology that store and/or deliver electrical energy. These sources can include batteries, supercapacitors, photovoltaic cells, wind power generators, fuel cells, electric vehicles, chargers with at least one battery storage, flywheels, gravity-based storages, compressed air storages, or any other energy storage devices capable of storing and delivering electrical power.

"Power converter module" preferably refers to a module within the multilevel converter that facilitates the conversion and/or control of electrical power. It includes circuitry, such as switching elements, to manipulate the flow of electrical energy and regulate voltage and current levels.

"Switching element" preferably refers to electronic devices, such as transistors or thyristors, used within the power converter module to control the flow of electric current. These elements can be turned on or off selectively to enable or interrupt the current path and facilitate the desired energy transfer or conversion.

"Diagnostic state" preferably refers to a state of the at least one of the plurality of power converter modules and/or the at least one of the plurality of energy sources in which the respective module(s) and/or energy source(s) may be available for running at least one diagnostic test for providing information, such as health and/or lifetime information about the at least one of the plurality of power converter modules and/or the at least one of the plurality of energy sources. The output of such a diagnostic test may be a voltage versus capacity curve for the at least one of the plurality of power converter modules and/or the at least one of the plurality of energy sources. The voltage data for the at least one of the plurality of power converter modules and/or the at least one of the plurality of energy sources may be post-processed to produce at least one dQ/dV curve. The peaks of such a dQ/dV curve may be isolated and compared to previous and/or historical test data. A shift may indicate an amount of loss of lithium inventory (LLI) and/or a loss of active material (LAM), in case the energy sources comprise at least one lithium, sodium-ion or any other suitable battery cell.

In the diagnostic state of the at least one of the plurality of power converter modules and/or the at least one of the plurality of energy sources, the power converter modules and/or energy sources not being in the diagnostic state may be configured for producing an alternating current (AC) output to the grid. The at least one of the at least one of the plurality of power converter modules and/or the at least one of the plurality of energy sources being in the diagnostic state may instead be configured for discharging a direct current output to a direct current-based energy storage, such as a DC-battery, e.g. an EV. This may require a separate current path in/out of the power converter module, which may be achieved via specific switching configuration(s) of the switching elements, which may connect the module and/or energy storage under diagnosis to a DC-energy storage instead of an AC output, such as the grid.

"Predetermined charge or discharge rate" may refer to a specific and/or preestablished speed and/or rate at which the at least one power converter module and/or the at least one energy source is/are charged with electrical energy or discharged of their stored energy. This rate may be set in advance and maintained consistently during the diagnostic state of the multilevel converter. It ensures that the charging or discharging process occurs at a known and controlled pace, allowing for precise monitoring and evaluation. The predetermined charge or discharge rate may include an arbitrary and/or steady and/or variable and/or stepwise and/or pulsating charge or discharge rate.

The at least one power converter module and/or the at least one energy source under diagnosis may also be observed without being discharged or charged to collect data of the at least one power converter module and/or the at least one energy source during a rest period and/or before or after charging or discharging the at least one power converter module and/or the at least one energy source.

"Predetermined criterion" may represent a predefined condition or threshold that may be met or exceeded during the diagnostic state of the multilevel converter. This condition may serve as a critical point of evaluation, indicating when the charging or discharging process has progressed sufficiently for the diagnostic state to conclude. Once this predetermined criterion is satisfied, it may trigger the transition of the at least one power converter module and/or the at least one energy source from the diagnostic state to a non-diagnostic state. Also, the predetermined criterion may be a period of time after the charge/ discharge has finished and the at least one power converter module and/or the at least one energy source has been left in a bypass state to rest the at least one power converter module and/or the at least one energy source for a predetermined time, in particular in order to collect rest data of the at least one power converter module and/or the at least one energy source.

"Non-diagnostic state" may refer to the operational mode of the multilevel converter and/or the at least one power converter module and/or the at least one energy source when it is not actively undergoing diagnostic testing or evaluation. In this state, the multilevel converter and/or the at least one power converter module and/or the at least one energy source may function in its regular operational mode, and it may not actively charge or discharge at the predetermined rate or monitoring against predetermined criteria. The transition from the diagnostic state to the non-diagnostic state may occur once the predefined criterion has been met, signifying that the testing or evaluation phase has been completed, and normal operation can resume without diagnostic constraints.

It shall be understood that particularly before the predetermined criterion is reached, a charging or discharging of the at least one of the plurality of power converter modules and/or the at least one of the plurality of energy sources may be performed, in case the at least one of the plurality of power converter modules and/or the at least one of the plurality of energy sources has been at least partly and/or at least temporarily discharged in the diagnostic state.

In one embodiment, the non-diagnostic state includes selectively switching the at least one of the plurality of power converter modules and/or the at least one of the plurality of energy sources into series positive and/or into series negative and/or in parallel with at least another one of the plurality of energy sources, preferably to generate a direct current and/or an alternating current at an output of the multilevel converter, and/or into a bypass state with respect to at least another one of the plurality of power converter modules and/or with respect to at least another one of the plurality of energy sources, and/or into an off-state and/or into a standby-state and/or into another diagnostic state.

Switching into series positive preferably means connecting the at least one power converter module and/or energy source in series with at least one other in a positive configuration, potentially to facilitate the generation of direct current (DC) and/or alternating current (AC) at the multilevel converter's output. Switching into series negative preferably means connecting the selected power converter module and/or energy source in series but in a negative configuration, which may also be utilized for DC and/or AC generation. Switching in parallel preferably means connecting the selected module and/or energy source in parallel with at least one other power converter module and/or energy source, potentially to influence the output characteristics of the multilevel converter. Bypass state preferably means switching the selected power converter module and/or energy source to divert it from the normal operational path with respect to at least one other power converter module and/or energy source. This may serve to isolate or protect the module/source or manage load distribution. Off-State preferably means partly or completely deactivating or shutting down the selected power converter module and/or energy source, thus, removing it from the multilevel converter to conserve energy or perform maintenance. Standby-state preferable means switching the selected power converter module and/or energy source in a standby or low-power mode, preferably ready for quick activation when needed. Another diagnostic state preferably means that the non-diagnostic state may involve transitioning the selected power converter module and/or energy source into another form of diagnostic state or testing, potentially with different parameters and/or objectives than the initial diagnostic state.

It shall be noted that if the at least one of the plurality of power converter modules and/or the at least one of the plurality of energy sources is back in the non-diagnostic state, the at least one of the plurality of power converter modules and/or the at least one of the plurality of energy sources may be included back into the regular switching schedule of the multilevel converter. If the state of charge (SoC) of the at least one of the plurality of power converter modules and/or the at least one of the plurality of energy sources permits, the at least one of the plurality of power converter modules and/or the at least one of the plurality of energy sources may resume providing an alternating current. Also, particularly if the multilevel converter may not be connected to a grid, thus being run in an offline mode, another one of the at least one of the plurality of power converter modules and/or another one of the at least one of the plurality of energy sources may charge or discharge the at least one of the plurality of power converter modules and/or the at least one of the plurality of energy sources that were in the diagnostic state to rebalance the SOC. Furthermore, it shall be noted that the at least one of the plurality of power converter modules and/or the at least one of the plurality of energy sources that exists from the diagnostic mode may be charged, in particular in a direct current (DC) mode, from an external power source, e.g. a solar panel, a fuel cell, a battery electric vehicle (BEV), and/or any other suitable DC source. It shall be understood that such a DC charging may include use of a further DC/DC converter.

In a further embodiment, the method further comprising, in the diagnostic state, discharging the electrical energy stored in the at least one of the plurality of power converter modules and/or in the at least one of the plurality of energy sources to at least another one of the plurality of power converter modules and/or to at least another one of the plurality of energy sources.

This configuration preferably describes an offline mode of the multilevel converter, particularly where the multilevel converter is not connected to an external grid, such as a single phase power grid or a three or multiphase power grid.

It may be preferable if a scheduler or a controller of the multilevel converter controls and/or schedules and/or issues discharging the electrical energy of the at least one of the plurality of power converter modules and/or the at least one of the plurality of energy sources to multiple other power converter modules and/or multiple other energy sources, for example, to level energy between different power converter modules and/or energy sources.

In a further embodiment, the multilevel converter comprises at least two electrical phases, a first one of which comprising the at least one of the plurality of power converter modules and/or the at least one of the plurality of energy sources and a second one of which comprising at least another one of the plurality of power converter modules and/or at least another one of the plurality of energy sources. Also, the method comprising, in the diagnostic state, discharging the electrical energy stored in the at least one of the plurality of power converter modules and/or in the at least one of the plurality of energy sources of the first phase to the at least another one of the plurality of power converter modules and/or to the at least another one of the plurality of energy sources of the second phase and/or in a third phase and/or within the same phase.

The multilevel converter comprises at least two "electrical phases". These phases may represent distinct parts and/or sections of the converter. The first phase may include certain "power converter modules" and/or "energy sources," while the second phase may include different "power converter modules" and/or "energy sources". The two phases may be connectable to respective phases of a power grid. The multilevel converter may comprise more than two phases. Particularly, the multilevel converter may comprise three or more phases. The phases may be connectable to a common star point and/or a delta connection. During the diagnostic state, there may be an action of "discharging the electrical energy" that is stored in the "power converter modules" and/or "energy sources" of the first phase to at least one "power converter module" and/or at least one "energy source" of the second phase. Thus, energy transfer between phases may be possible according to this embodiment. Said discharged energy may thus be directed and/or transferred to the "power converter modules" and/or "energy sources" of the second phase.

In a further embodiment, the method further comprises selectively switching at least another one of the plurality of power converter modules and/or at least another one of the plurality of energy sources at least in series positive and/or in series negative with at least a further one of the plurality of power converter modules and/or with at least a further one of the plurality of energy sources to generate the alternating current at the output of the multilevel converter, when the at least one of the plurality of power converter modules and/or the at least one of the plurality of energy sources is in the diagnostic state and being charged from an external energy source or being discharged to an external load.

In this scenario, the multilevel converter may be connected or connectable to a grid. In grid connecting, the multilevel converter may be run in a so-called online mode. Only the at least one of the plurality of power converter modules and/or the at least one of the plurality of energy sources being in the diagnostic state may be discharged to an external load or may be charged by an external energy storage or energy providing source. At the same time, the at least another one of the plurality of power converter modules and/or the at least another one of the plurality of energy sources being connectable at least in series positive and/or in series negative with the at least a further one of the plurality of power converter modules and/or with the at least a further one of the plurality of energy sources may discharge to the grid or charged by the grid.

In a further embodiment, the method further comprises selectively switching at least another one of the plurality of power converter modules and/or at least another one of the plurality of energy sources at least in series positive and/or in series negative with at least a further one of the plurality of power converter modules and/or with at least a further one of the plurality of energy sources to generate the direct current and/or the alternating current at the output of the multilevel converter, when the at least one of the plurality of power converter modules and/or the at least one of the plurality of energy sources is in the diagnostic state.

Specifically, this may be the case in an "offline mode", i.e., when the multilevel converter is not connected to the grid. Thereby, the energy from the at least another one of the plurality of power converter modules and/or the at least another one of the plurality of energy sources being connectable at least in series positive and/or in series negative with the at least a further one of the plurality of power converter modules and/or with the at least a further one of the plurality of energy sources may be charged by or discharged to an external energy storage, i.e., a battery or a BEV, wherein the external energy storage is electrically isolated from the grid. Also, the discharging may be performed to an external load.

In a further embodiment, the method further comprising charging or discharging the at least one of the plurality of power converter modules and/or the at least one of the plurality of energy sources, being in the diagnostic state, with a predetermined charge or discharge current that is different from at least one charge or discharge current of at least another one of the plurality of power converter modules and/or at least another one of the plurality of energy sources.

In other words, the at least one of the plurality of power converter modules and/or the at least one of the plurality of energy sources being under diagnosis can be charged or discharged with a predetermined charge or discharge current that may be specifically set for performing diagnosis and therefore, is different from a charge or discharge current applied to the at least another one of the plurality of power converter modules and/or the at least another one of the plurality of energy sources being in a normal or non-diagnostic state. The predetermined charge or discharge current may be arbitrary and/or steady and/or variable and/or stepwise and/or pulsating.

It is to be noted that data, particularly as measurement data, may be collected from the at least one of the plurality of power converter modules and/or the at least one of the plurality of energy sources under diagnosis. Such collected data may preferably be used for testing of the at least one of the plurality of power converter modules and/or the at least one of the plurality of energy sources and/or may be stored. Alternatively or additionally, the collected data may be used to dynamically set end conditions of the diagnostic test and/or for further manual and/or automated analysis. Such analysis, over time, may also affect operating conditions.

In a further embodiment, a time pulse and/or a C-Rate for charging or discharging of the at least one of the plurality of power converter modules and/or the at least one of the plurality of energy sources, being in the diagnostic state, is different from a further time pulse and/or a further C-Rate for charging or discharging of the at least another one of the plurality of power converter modules and/or the at least another one of the plurality of energy sources.

"Time pulse" may be understood as a parameter for charging or discharging the at least one of the plurality of power converter modules and/or the at least one of the plurality of energy sources. A time pulse may be a measure of time duration used in controlling the charging and/or discharging.

"C-Rate" may be understood as a parameter for charging or discharging the at least one of the plurality of power converter modules and/or the at least one of the plurality of energy sources. In battery technology, the C-Rate is a measure of charge and discharge rates relative to the battery's capacity. It indicates how quickly or slowly a battery is charged or discharged.

In other words, the mentioned parameters (time pulse and/or C-Rate) used for charging or discharging the at least one of the plurality of power converter modules and/or the at least one of the plurality of energy sources in the diagnostic state are "different from a further time pulse and/or a further C-Rate for charging or discharging of the at least another one of the plurality of power converter modules and/or the at least another one of the plurality of energy sources." This means that different components within the multilevel converter may be subject to different time pulses and/or C-Rates during the diagnostic state.

In a further embodiment, the method further comprising, when the predetermined criterion is reached, after selectively switching the at least one of the plurality of power converter modules and/or the at least one of the plurality of energy sources; charging or discharging the at least one of the plurality of power converter modules and/or the at least one of the plurality of energy sources to balance the state of charge of the at least one of the plurality of power converter modules and/or the at least one of the plurality of energy sources with respect to the other ones of the plurality of power converter modules and/or with respect to the other ones of the plurality of energy sources.

This balancing and/or leveling of energy between the power converter module and/or the energy source, having been diagnosed, may be controlled by a controller or scheduler of the multilevel converter. The balancing and/or leveling may be performed until the power converter module and/or the energy source, having been diagnosed, may have the same energy as its neighboring and/or adjacent power converter modules and/or the energy sources.

In a further embodiment, the method further comprising, in the diagnostic state, discharging the electrical energy stored in the at least one of the plurality of power converter modules and/or in the at least one of the plurality of energy sources to the output of the multilevel converter.

Said energy may be deliverable to a grid, in a case where the multilevel converter is connected to the grid. Alternatively, said energy may be delivered to an external load connectable to at least one phase of the multilevel converter, wherein the diagnosed power converter module and/or energy source preferably being in this phase.

In a further embodiment, the method further comprising, in the diagnostic state, discharging the at least one of the plurality of power converter modules and/or the at least one of the plurality of energy sources, when the at least one of the plurality of power converter modules and/or the at least one of the plurality of energy sources reaches a predetermined threshold, in particular a predetermined temperature and/or a predetermined state of charge, SOC, and/or a predetermined voltage, and/or a predetermined time, and/or a predetermined system control signal, and/or a predetermined current, and/or a predetermined temperature, and/or a predetermined state of energy.

There may be more than one predetermined threshold. There may be predetermined thresholds having different weights. The predetermined threshold may be used as a criterion to initiate the diagnostic state. Thus, the at least one predetermined threshold may be used as a trigger to switch the respective power converter module and/or energy source in the diagnostic state.

In a further embodiment, each of the plurality of energy sources comprises at least one battery and/or at least one capacitor and/or at least one photovoltaic panel. Preferably, the each of the plurality of energy sources may comprise energy of a wind turbine output that is rectified to direct current. Also, the each of the plurality of energy sources may comprise at least one load, such as a residential storage battery and/or a battery of an electric vehicle.

In a further embodiment, the method further comprising, performing a state of charge balancing of the plurality of power converter modules and/or the plurality of energy sources.

The primary action described in the claim is the "performing a state of charge balancing". This refers to a process of equalizing or adjusting the charge levels of the plurality of power converter modules and/or the plurality of energy sources.

In accordance with a second aspect, a multilevel converter is provided comprising a plurality of energy sources, a plurality of power converter modules and a controller, each power converter module comprising at least two switching elements; at least one of the plurality of power converter modules being configured to selectively switch at least one of the plurality of power converter modules and/or at least one of the plurality of energy sources at least temporarily into a diagnostic state, wherein, in the diagnostic state, the at least one of the plurality of power converter modules and/or the at least one of the plurality of energy sources is caused to be charged or discharged at a predetermined charge or discharge rate or observed until a respective predetermined criterion is reached, and wherein, when the predetermined criterion is reached, the at least one of the plurality of power converter modules and/or the controller being configured to selectively switch the at least one of the plurality of power converter modules and/or the at least one of the plurality of energy sources from the diagnostic state into series positive and/or into series negative and/or in parallel with at least another one of the plurality of energy sources to generate a direct current and/or an alternating current at an output of the multilevel converter, and/or into a bypass state with respect to at least another one of the plurality of power converter modules and/or with respect to at least another one of the plurality of energy sources.

The selectively switching of the at least one of the plurality of power converter modules and/or the at least one of the plurality of energy sources at least temporarily into a diagnostic state by means of the at least one of the plurality of power converter modules may be initiated and/or performed and/or triggered by means of the controller. The controller may be a scheduler or another kind of control unit.

All features and/or expressions and/or terms detailed for the claimed method apply, mutatis mutandis, for the claimed multilevel converter.

In one embodiment, the multilevel converter comprising at least one measurement unit being configured to measure at least a voltage of the at least one of the plurality of power converter modules and/or the at least one of the plurality of energy sources, when the at least one of the plurality of power converter modules and/or the at least one of the plurality of energy sources is charged or discharged in the diagnostic state.

There may be more than one measurement sensor and/or measurement unit present in the multilevel converter. Such measurement sensors and/or measurement units may be configured for current and/or temperature measurements. The multilevel converter may be equipped with multiple sensors for supervising the module and/or energy source under diagnosis and/or the remaining energy sources.

In accordance with a third aspect, an electric vehicle is provided comprising at least one multilevel converter according to any one of its embodiments, wherein the multilevel converter being configured as a battery, preferably as a traction battery.

All aspects and embodiments as described above may be combined as deemed fit by the skilled person.

"A(n)" in the present case should not necessarily be understood to be restrictive to exactly one element. Rather, a plurality of elements, such as, for example, two, three or more, can also be provided. Any other numeral used here, too, should not be understood to the effect that there is a restriction to exactly the stated number of elements. Rather, numerical deviations upwards and downwards are possible, unless indicated to the contrary.

Further possible implementations of the invention also comprise not explicitly mentioned combinations of any features or embodiments that are described above or below with respect to the exemplary embodiments. In this case, a person skilled in the art will also add individual aspects as improvements or supplementations to the respective basic form of the invention.

### DESCRIPTION OF THE FIGURES

Fig. 1 shows a flowchart of a method for controlling a multilevel converter according to an embodiment of the present invention;
Fig. 2 shows a refinement of a multilevel converter being configured for grid connection;
Fig. 3 shows a further schematic refinement of a multilevel converter having a first topology;
Fig. 4 shows a further schematic refinement of a multilevel converter having a second topology; and
Fig. 5 shows a further schematic refinement of a multilevel converter having a third topology.

### DETAILED DESCRIPTION OF THE INVENTION

Unless indicated to the contrary, elements that are the same or functionally the same have been given the same reference signs in the figures. It should also be noted that the illustrations in the figures are not necessarily true to scale.

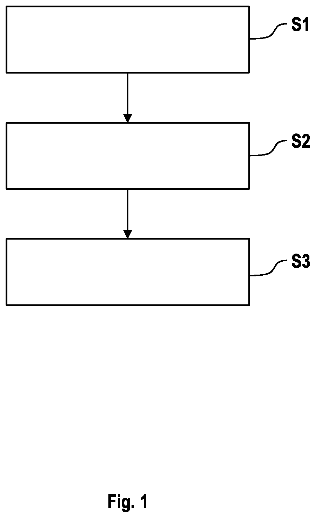

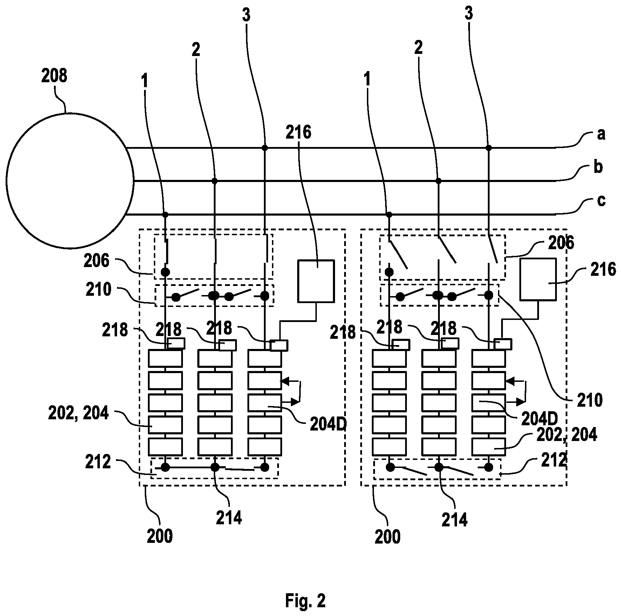

Fig. 1 shows a flowchart of a method for controlling a multilevel converter according to an embodiment of the present invention. The method for controlling a multilevel converter 200 comprising a plurality of energy sources 2600 and a plurality of power converter modules 204, each power converter module 204 comprising at least two switching elements 2800 (see Figs. 2 to 5).

The method comprises in a step S1 selectively switching at least one of the plurality of power converter modules 204 and/or at least one of the plurality of energy sources 2600 into a diagnostic state.

The method comprises in a step S2, in the diagnostic state, charging or discharging the at least one of the plurality of power converter modules 204 and/or the at least one of the plurality of energy sources 2600 at a predetermined charge or discharge rate until a predetermined criterion is reached.

The method comprises in a step S3, when the predetermined criterion is reached, selectively switching the at least one of the plurality of power converter modules 204 and/or the at least one of the plurality of energy sources 2600 from the diagnostic state into a non-diagnostic state.

Fig. 2 shows a refinement of the multilevel converter 200 being configured for grid connection. In Fig. 2, for example, two multilevel converters 200 are shown, both comprising the same or a similar topology. The respective multilevel converter 200 comprises in this example three phases, each of which comprises five power converter modules 204 as well as respective energy sources 2600. The three phases of each multilevel converter 200 are indicated by numbering 1, 2, 3, respectively. The respective multilevel converter 200 comprises, preferably phase-individual, grid terminal connectors 206 arranged on each phase 1, 2, 3. The respective grid terminal connector 206 may be configured to connect the respective phase 1, 2, 3 of the respective multilevel converter 200 to a corresponding, respective grid phase a, b, c of a power grid 208. The grid terminal connectors 208 may be contactors or another kind of switch elements. The respective multilevel converter 200 may comprise interphase connectors 210 on a grid-connecting side of the respective multilevel converter 200, the interphase connectors 210 being preferably arranged between phase 1 and 2, as well as between phase 2 and 3. Of course, in other refinements, the interphase connectors 210 may also be arranged between phase 1 and 3. The interphase connectors 210 may be contactors or another kind of switch elements. The interphase connectors 210 may be configured to connect phases 1 and 2 and/or phases 2 and 3 with one another. Also, the respective multilevel converter 200 may comprise common star point connectors 212. The star point connectors 212 may be arranged on a common star point 214 side of the respective multilevel converter 200, the star point connectors 212 being preferably arranged between phase 1 and 2, as well as between phase 2 and 3. The star point connectors 212 may be configured to connect the three phases to the common star point 214. In such a case, the interphase connectors preferably remain open. By selectively closing the interphase connectors 210 and/or the star point connectors 212, at least two of the three phases 1, 2, 3 may be connectable at least temporarily in series (positive and/or negative) and/or in parallel with one another. The left-handed multilevel converter 200 is shown in a grid connection, thus with closed grid connectors 206. Furthermore, the left-handed multilevel converter 200 is shown with closed star point connectors. The right-handed multilevel converter 200 is shown without grid connection, thus with opened grid connectors 206. Furthermore, the right-handed multilevel converter 200 is shown with opened star point connectors. Both multilevel converters 200 are shown with opened interphase connectors.

Each multilevel converter 200 may comprise a (main) controller 216. In other configurations, such a controller may be used for controlling multiple multilevel converters 200. Furthermore, the respective multilevel converter 200 may comprise, preferably phase individual, slave controllers 218 that may be represented as schedulers. The controller 216 is preferably configured to control switching operations of the respective multilevel converter 200 that relate to all three phases 1, 2, 3. The slave controllers / schedulers 218 may be configured to control the power converter modules and/or the energy sources arranged on each of the phases. The slave controllers / schedulers 218 may be configured to receive a control map from the main controller 216, preferably including gate switching signals for switching the at least two switching elements 2800.

Also, according to Fig. 2, for each multilevel converter 200 a power converter module 204 being in the diagnostic state is shown and indicated by 204D. According to the invention, an energy transfer between the power converter module under diagnosis 204D and a neighboring power converter module 204 is possible and indicated by respective arrows.

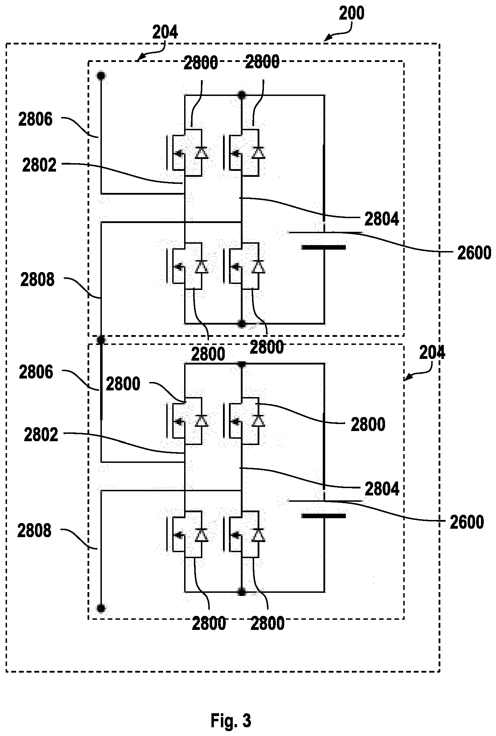

Fig. 3 shows a schematic refinement of a multilevel converter 200 having an exemplary topology. It is to be specifically mentioned that this is only one possible configuration. There are multiple other topologies of a multilevel converter 200 that can be used. Particularly, Fig. 3 shows a potential switching setup for the multilevel converter 200. The multilevel converter 200 exemplarily comprises at least two power converter modules 204 that may be similar to those shown in Fig. 2. Also, the multilevel converter 200 further comprising at least two energy sources 2600, wherein at least one of the energy sources 2600 is comprised in each of the power converter modules 204. Each of the at least two energy sources 2600 comprises at least one battery cell and/or at least one capacitor and/or at least one photovoltaic panel. The power converter module 204 being configured to selectively switch the at least one energy source 2600 of the respective module with respect to the other energy source 2600 at least temporarily in series positive or in series negative or in parallel to generate a controllable alternating or direct current at the output of the multilevel converter 200. The power converter module 204 exemplarily includes four switching elements 2800. In other topologies, a different number of switching elements 2800 may be used. Two respective switching elements 2800 are provided per module string 2802, 2804 of the exemplary multilevel converter 200 in series connection. Between each of the two switching elements 2800 per string 2802, 2804 a respective further terminal connection 2806, 2808 is provided. The terminal connections 2806, 2808 may be used to modularly connect multiple power converter modules 204 and/or respective modules and/or respective multilevel converters 200 together.

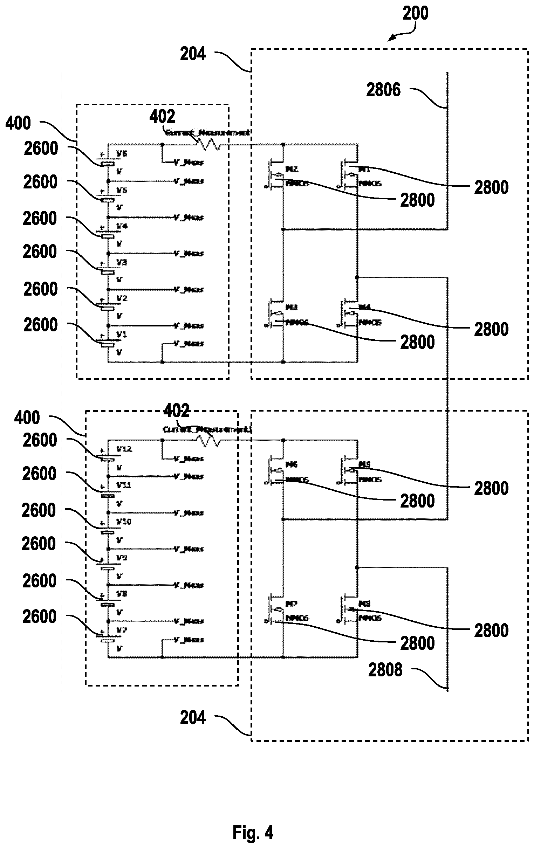

Fig. 4 shows a schematic refinement of a multilevel converter 200 having an exemplary topology. The topology is very similar to the topology shown in Fig. 3 but differs in the number of energy sources 2600 connected in series to one another for each power converter module 204. The energy sources 2600 may be considered as energy source modules or stacks 400. Also, differing from the refinement of Fig. 3, the topology of Fig. 4 includes at least one measurement unit 402. The at least one measurement unit 402 may be configured for current measurement. According to this topology of the multilevel converter 200, energy transfer between the respective power converter modules 204 may not be possible. However, energy transfer between different phases 1, 2, 3 is possible. The topology may be considered as a double H-bridge configuration. In said configuration of the multilevel converter 200, it may be suitable to perform the diagnostic state of all power converter modules 204 and/or the respective energy sources 202 being arranged in a respective phase 1, 2, 3.

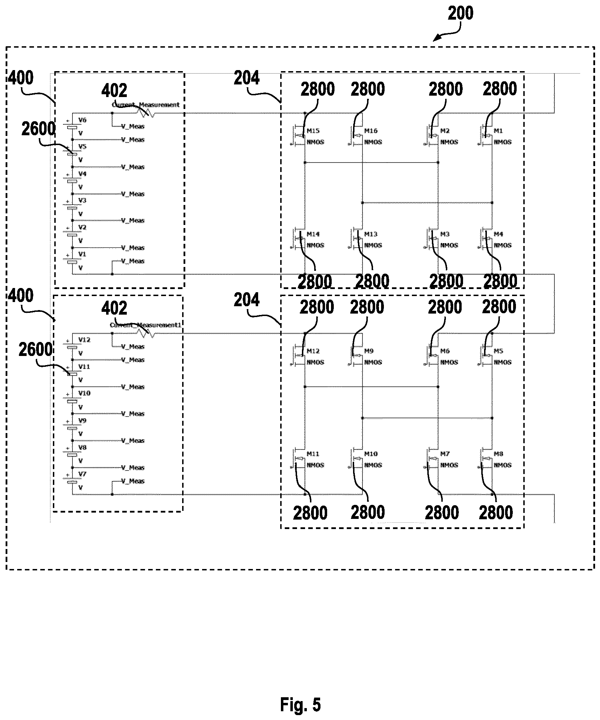

Fig. 5 shows a schematic refinement of a multilevel converter 200 having an exemplary topology. Therein, the power converter modules 204 include eight switching elements 2800. The two power converter modules 204 together with the respective energy sources 202 are connected in series with one another. In this configuration, energy transfer between the two shown power converter modules 204 is possible. Also, energy transfer between phases 1, 2, 3 is possible.

In one possible scenario of the provided method, the multilevel converter 200 may have a predetermined number of power converter modules 204. One power converter module 204 may be removed when a particular condition / a predetermined criterion is reached, e.g., temperature = 25°C, SOC = 80% SOC. The power converter module 204D may perform, being in the diagnostic state, a discharge test. Thereby, the scheduler 218 may dynamically adjust the remaining power converter module's power and/or voltage outputs to incorporate a constant current discharge. The scheduler 218 may cycle through all power converter modules 204 in the multilevel converter 200, preferably ensuring each power converter module contributes an equal share of energy, hence balancing the overall SOC. Also, a diagnostic testing may be performed on one power converter module 204D, wherein the scheduler 218 may remove said module 204D from the schedule, and may thus continue schedule of output with the remaining power converter modules 204, not being under diagnosis. If the power converter module 204D being in the diagnostic state is at a predetermined SOC, i.e., 80% SOC, a discharge may start at a constant current discharge rate, i.e., at C/4. This discharge may create a DC offset in the output of the multilevel converter 200. To compensate, the scheduler 218 may alter the schedule to switch in power converter modules 204 in such a way that a DC offset with opposite sense is created, to balance out the diagnostic module DC offset, preferably whilst maintaining an AC output. Once the power converter module 204D reaches 0% SOC, the diagnostic test may stop and power converter module 204D may be included back into the schedule as a normal power converter module 204. Because the SOC of the former power converter module 204D may be much lower due to testing than an SOC of the neighboring power converter modules 204, the formerly tested power converter module 204 may only be included in charging operations until its SOC realigns with the rest of the system. After that, a further power converter module 204 may be brought in a diagnostic state to perform testing.

In one possible scenario of the provided method, the multilevel converter 200 may be operational, pairs of power converter modules 204 may be removed, preferably sequentially, for diagnostic tests. The energy output from one power converter module 204 may be used for charging at least one of the remaining power converter modules 204. In this scenario, no energy output from the diagnostic test may contribute to the output of the multilevel converter 200. Thus, the multilevel converter may not be connected to the power grid 208. This is similar to the above scenario, however the scheduler 218 may perform a different form of readjustment. The starting condition for testing several power converter modules 204 may be that all power converter modules 204 are at a predetermined SOC, e.g., 50% SOC. The scheduler 218 may cycle through all power converter modules 204 of the multilevel converter 200, thereby ensuring that each power converter module 204 may contribute an equal share of energy, hence balancing an overall SOC. Also, a diagnostic testing may be performed on one power converter module 204D, wherein the scheduler 218 may remove said module 204D from the schedule, and may thus continue schedule of output with the remaining power converter modules 204, not being under diagnosis. If the power converter module 204D being in the diagnostic state is at a predetermined SOC, i.e., 50% SOC, a discharge may start at a constant current discharge rate, i.e., at C/4. This discharge may create a DC offset in the output of the multilevel converter 200. To compensate, the scheduler 218 may alter the schedule to switch in power converter modules 204 in such a way that a DC offset with opposite sense is created, to balance out the diagnostic module DC offset, preferably whilst maintaining an AC output. Thereby, energy from the power converter module(s) 204D flows to the remaining power converter modules 204. Once the power converter module 204D reaches 0% SOC, the diagnostic test may stop and power converter module 204D may be included back into the schedule as a normal power converter module 204. However, its SOC is low, that it cannot provide energy to the overall output. However, the remaining power converter modules 204 have been charged with its energy. Thus, at least one of the remaining power converter modules 204 having been charged with the energy of the power converter module 204D that was under diagnosis, may now be removed for from the schedule for a diagnostics test. Energy of the now tested power converter module 204D can be charged back to the formerly diagnosed power converter module to charge it back up to its original SOC or any predecided SOC. Once the next power converter module 204 finished diagnosis, diagnosis repeats until all power converter modules 204 have been tested and preferably finished discharging. At this stage, the last power converter module 204 that has been tested is the only power converter module 204 left at low SOC, and the energy from the initially tested power converter module 204 that is now residing in all not-tested power converter modules 204 may be used to re-charge the last tested power converter module 204 back to the overall SOC of the multilevel converter 200.

### LIST OF REFERENCE SIGNS

- 1: phase
- 2: phase
- 3: phase
- 200: multilevel converter
- 204: power converter module
- 204D: power converter module in diagnostic state
- 206: grid terminal connector
- 208: power grid
- 210: interphase connectors
- 212: star point connectors
- 214: common star point
- 216: controller
- 218: slave controller/scheduler
- 400: energy source module
- 402: measurement unit
- 2600: energy sources
- 2800: switching elements
- 2802: module string
- 2804: module string
- 2806: terminal connection
- 2808: terminal connection
- a: grid phase
- b: grid phase
- c: grid phase
- S1: step "selectively switching"
- S2: step "in the diagnostic state, charging or discharging"
- S3: step "when the predetermined criterion is reached, selectively switching"

## Claims

1. A method for controlling a multilevel converter (200) comprising a plurality of energy sources (2600) and a plurality of power converter modules (204), each power converter module (204) comprising at least two switching elements (2800), the method comprising:
selectively switching at least one of the plurality of power converter modules (204) and/or at least one of the plurality of energy sources (2600) into a diagnostic state;
in the diagnostic state, charging or discharging the at least one of the plurality of power converter modules (204) and/or the at least one of the plurality of energy sources (2600) at a predetermined charge or discharge rate or observing the at least one of the plurality of power converter modules and/or the at least one of the plurality of energy sources (2600) until a respective predetermined criterion is reached, and
when the predetermined criterion is reached, selectively switching the at least one of the plurality of power converter modules (204) and/or the at least one of the plurality of energy sources (2600) from the diagnostic state into a non-diagnostic state.

2. Method of claim 1, wherein the non-diagnostic state includes selectively switching the at least one of the plurality of power converter modules (204) and/or the at least one of the plurality of energy sources (2600) into series positive and/or into series negative and/or in parallel with at least another one of the plurality of energy sources (2600) and/or into a bypass state with respect to at least another one of the plurality of power converter modules (204) and/or with respect to at least another one of the plurality of energy sources (2600), and/or into an off-state and/or into a standby-state and/or into another diagnostic state.

3. Method of claim 1 or 2 further comprising, in the diagnostic state, discharging the electrical energy stored in the at least one of the plurality of power converter modules (204) and/or in the at least one of the plurality of energy sources (2600) to at least another one of the plurality of power converter modules (204) and/or to at least another one of the plurality of energy sources (2600).

4. Method of any one of the preceding claims,
wherein the multilevel converter (200) comprises at least two electrical phases (1,2,3), a first (1) one of which comprising the at least one of the plurality of power converter modules (204) and/or the at least one of the plurality of energy sources (2600) and a second (2) one of which comprising at least another one of the plurality of power converter modules (204) and/or at least another one of the plurality of energy sources (2600),
wherein the method comprising: in the diagnostic state, discharging the electrical energy stored in the at least one of the plurality of power converter modules (204) and/or in the at least one of the plurality of energy sources (2600) of the first phase (1) to the at least another one of the plurality of power converter modules (204) and/or to the at least another one of the plurality of energy sources (2600) of the second phase (2).

5. Method of claim 1 or 2, further comprising:
selectively switching at least another one of the plurality of power converter modules (204) and/or at least another one of the plurality of energy sources (2600) at least in series positive and/or in series negative with at least a further one of the plurality of power converter modules (204) and/or with at least a further one of the plurality of energy sources (2600) to generate the alternating current at the output of the multilevel converter (200), when the at least one of the plurality of power converter modules (204) and/or the at least one of the plurality of energy sources (2600) is in the diagnostic state and being charged form an external energy source or being discharged to an external load.

6. Method of claim 5, further comprising:
charging or discharging the at least one of the plurality of power converter modules (204) and/or the at least one of the plurality of energy sources (2600), being in the diagnostic state, with a predetermined charge or discharge current that is different from at least one charge or discharge current of at least another one of the plurality of power converter modules (204) and/or at least another one of the plurality of energy sources (2600).

7. Method of claim 6, wherein a time pulse and/or a C-Rate for charging or discharging of the at least one of the plurality of power converter modules (204) and/or the at least one of the plurality of energy sources (2600), being in the diagnostic state, is different from a further time pulse and/or a further C-Rate for charging or discharging of the at least another one of the plurality of power converter modules (204) and/or the at least another one of the plurality of energy sources (2600).

8. Method of any one of the preceding claims, further comprising, when the predetermined criterion is reached, after selectively switching the at least one of the plurality of power converter modules (204) and/or the at least one of the plurality of energy sources (2600);
charging or discharging the at least one of the plurality of power converter modules (204) and/or the at least one of the plurality of energy sources (2600) to balance the state of charge of the at least one of the plurality of power converter modules (204) and/or the at least one of the plurality of energy sources (2600) with respect to the other ones of the plurality of power converter modules (204) and/or with respect to the other ones of the plurality of energy sources (2600).

9. Method of any one of the preceding claims further comprising, in the diagnostic state, discharging the electrical energy stored in the at least one of the plurality of power converter modules (204) and/or in the at least one of the plurality of energy sources (2600) to the output of the multilevel converter (200).

10. Method of any one of the preceding claims further comprising, in the diagnostic state, discharging the at least one of the plurality of power converter modules (204) and/or the at least one of the plurality of energy sources (2600), when the at least one of the plurality of power converter modules (204) and/or the at least one of the plurality of energy sources (2600) reaches a predetermined threshold, in particular a predetermined temperature and/or a predetermined state of charge, SOC, and/or a predetermined voltage, and/or a predetermined time, and/or a predetermined system control signal, and/or a predetermined current, and/or a predetermined temperature, and/or a predetermined state of energy.

11. Method of any one of the preceding claims, wherein each of the plurality of energy sources (2600) comprises at least one battery and/or at least one capacitor and/or at least one photovoltaic panel.

12. Method of any one of the preceding claims, further comprising:
performing a state of charge balancing of the plurality of power converter modules (204) and/or the plurality of energy sources (2600).

13. Multilevel converter (200) comprising a plurality of energy sources (2600), a plurality of power converter modules (204) and a controller (216, 218),
each power converter module (204) comprising at least two switching elements (2800);
at least one of the plurality of power converter modules (204) being configured to selectively switch at least one of the plurality of power converter modules (204) and/or at least one of the plurality of energy sources (2600) at least temporarily into a diagnostic state,
wherein, in the diagnostic state, the at least one of the plurality of power converter modules (204) and/or the at least one of the plurality of energy sources (2600) is caused to be charged or discharged at a predetermined charge or discharge rate or observed until a respective predetermined criterion is reached, and
wherein, when the predetermined criterion is reached, the at least one of the plurality of power converter modules (204) and/or the controller (216, 218) being configured to selectively switch the at least one of the plurality of power converter modules (204) and/or the at least one of the plurality of energy sources (2600) from the diagnostic state into series positive and/or into series negative and/or in parallel with at least another one of the plurality of energy sources (2600) to generate a direct current and/or an alternating current at an output of the multilevel converter (200), and/or into a bypass state with respect to at least another one of the plurality of power converter modules (204) and/or with respect to at least another one of the plurality of energy sources (2600).

14. Multilevel converter (200) of claim 13 further comprising at least one measurement unit (402) being configured to measure at least a voltage of the at least one of the plurality of power converter modules (204) and/or the at least one of the plurality of energy sources (2600), when the at least one of the plurality of power converter modules (204) and/or the at least one of the plurality of energy sources (2600) is charged or discharged in the diagnostic state.

15. Electric vehicle comprising at least one multilevel converter (200) of claim 13 or 14, the multilevel converter (200) being configured as a battery.
